# FASCICULE DE BREVET EUROPEEN

(11) **EP 2 426 627 B1**
(45) Date de publication et mention de la délivrance du brevet: **12.10.2016**
(21) Numéro de dépôt: 11179466.5
(22) Date de dépôt: 31.08.2011
(51) Int. Cl.: G06K 19/077

(54) **Module lumineux pour dispositif à microcircuit**
Leuchtmodul für Mikroschaltungsvorrichtung
Luminous module for a microcircuit device

(30) Priorité: 02.09.2010 FR 1056975; 02.09.2010 FR 1056974
(43) Date de publication de la demande: 07.03.2012
(73) Titulaire: Oberthur Technologies, 92300 Levallois-Perret (FR)
(72) Inventeur: Le Garrec, Loïc, 35500 Vitré (FR); Duval, Agnès, 35500 Vitré (FR); Vere, Denis, 35270 Argentre du Plessis (FR)
(74) Mandataire: Cougard, Jean-Marie

(56) Documents cités:
- WO-A1-2005/027036
- JP-A- 2004 265 176
- US-A- 5 345 367
- US-A1- 2008 054 077
- US-A1- 2008 282 540
- US-A1- 2009 167 495

## Description

La présente invention concerne un module pour dispositif électronique et un dispositif électronique comprenant un tel module.

L'invention s'applique notamment à tout type de dispositifs électroniques portables ou de poche pouvant incorporer un tel module, tels qu'une clé USB, une étiquette RFID (acronyme anglais pour « Radio Frequency IDentity»), une carte à puce, etc.

L'invention s'applique plus particulièrement mais non exclusivement aux cartes à microcircuit munies d'une antenne, telles que les cartes dites sans contact permettant d'établir une communication sans contact à une fréquence de communication prédéfinie avec un terminal externe, telle que par exemple la fréquence 13,56 MHz définie par la norme ISO 14 443.

Elle s'applique également encore aux cartes dites hybrides ou duales, permettant d'établir en plus de la communication sans contact, une communication avec contact par l'intermédiaire d'une interface de contacts externes, apte à venir en contact avec un lecteur adapté.

Généralement, le module comprend un support électriquement non conducteur qui porte le microcircuit sur l'une de ses faces et dans le cas des cartes à contact, une interface de contacts externes sur la face opposée, cette interface étant raccordée électriquement au microcircuit par exemple au travers du support.

Les cartes duales comprennent généralement un corps qui incorpore l'antenne ainsi que le module électronique, logé dans une cavité ménagée dans le corps.

L'antenne et le microcircuit sont alors classiquement raccordés électriquement au moyen de pastilles métalliques lors de l'encartage du module dans le corps.

Un tel agencement structurel permet d'obtenir une relativement bonne portée de communication car les dimensions de l'antenne sont maximisées dans la limite des dimensions du corps de carte. Toutefois, le raccordement du microcircuit à l'antenne présente un certain nombre d'inconvénients, notamment en termes de fiabilité et de rendement de fabrication.

Afin de remédier à ces inconvénients, il est ainsi connu d'intégrer l'antenne directement dans le module électronique, par exemple sur le support portant le microcircuit et ensuite de reporter le module dans le corps de la carte selon les techniques traditionnelles d'encartage des cartes classiques à contact.

Habituellement, les dimensions du support sont limitées aux dimensions de l'interface de contacts externes de forme générale carrée ou circulaire de sorte que le support est entièrement masqué par l'interface métallique.

Mais l'incorporation de l'antenne dans le module impose d'augmenter sensiblement les dimensions de ce support de manière à ce que l'antenne ait une surface utile de réception du champ magnétique suffisante pour conserver une portée de communication satisfaisante.

Or, dans ce cas, une relativement grande surface du support est non recouverte par l'antenne et par l'interface de contacts externes, l'antenne s'étendant généralement en périphérie du support. Cette surface du support à l'état brut produit un effet particulièrement inesthétique dans la carte et donne une impression de fabrication médiocre.

JP2004265176 divulgue une carte à microcircuit alimentée disposant d'un système d'affichage alimenté en énergie indépendamment par une antenne.

US2008/0054077 divulgue une carte de transaction comprenant un élément sensoriel tel qu'un circuit électrique pour produire de la lumière, pour par exemple éclairer les numéros ou produire un affichage graphique.

WO2005/027036 divulgue une carte d'identification comprenant des moyens d'émission de lumière pour émettre l'information d'identification.

US2009/0167495 divulgue une étiquette RFID comprenant une diode lumineuse qui est commandée pour transmettre le numéro d'identification de l'étiquette.

US2008/0282540 divulgue une méthode de fabrication de cartes à microcircuit utilisant des adhésifs thermoactivables isotropiques.

US 5,345,367 divulgue une carte PCMIA comportant un moyen lumineux, visible lorsque la carte est insérée dans un ordinateur.

L'invention a notamment pour but de remédier à ces inconvénients.

A cet effet, l'invention concerne un module électronique apte à être monté sur une cavité du corps d'un dispositif électronique, tel qu'une carte à microcircuit, ce module comprenant un support délimitant des première et deuxième faces externes opposées, la première face externe étant destinée à être tournée vers l'extérieur du dispositif électronique de sorte à être visible, la deuxième face externe étant destinée à être agencée en regard d'un fond de la cavité, ce module comportant une source lumineuse portée par la deuxième face externe et de sorte à éclairer la première face externe du support au travers du support.

Ainsi, une premier variante de réalisation de l'invention a pour objet un module électronique pour dispositif électronique, tel qu'une carte à microcircuit, comprenant un support délimitant des première et deuxième faces opposées, ce module comprenant une source lumineuse portée par la deuxième face du support et apte à éclairer la première face au travers du support.

Dans cette première variante de l'invention, la source lumineuse permet de rétro-éclairer le module lorsqu'elle est alimentée ce qui améliore sensiblement l'aspect visuel du dispositif, par exemple d'une carte à puce, en produisant un effet de grande technicité. En outre, comme la source est directement portée par le module, la fabrication de la carte selon l'invention est relativement simple et est compatible avec les procédés d'encartage classiques.

Un module selon cette première variante de l'invention peut en outre comporter l'une ou plusieurs des caractéristiques suivantes :
- le support comporte une région de transmission lumineuse s'étendant entre les deux faces ;
- la première face est destinée à être visible et la deuxième face est destinée à être masquée lorsque le module est monté dans le dispositif électronique ;
- le support porte sur la première face un motif et la source lumineuse est agencée pour rétro-éclairer le motif ;
- le module comprend un microcircuit porté par la deuxième face du support ;
- le module comprend une interface de contacts externes raccordée au microcircuit et portée par la première face du support ;
- le module comprend une antenne de communication en champ proche raccordée au microcircuit et portée par le support du module ;
- le support a une forme générale oblongue ;
- la source lumineuse comprend une diode électroluminescente ;
- la source lumineuse est agencée pour éclairer le support en lumière directe ;
- la source lumineuse est formée par un organe comprenant une partie émettrice de lumière agencée au moins partiellement en regard du support ;
- le support est réalisé dans un matériau comprenant essentiellement du verre-époxy.

L'invention a encore pour objet un dispositif électronique, tel qu'une carte à microcircuit, comprenant un module et un corps muni d'une cavité de réception du module, le module étant conforme à cette première variante de réalisation de l'invention, la deuxième face du support étant agencée en regard d'un fond de la cavité.

De préférence, ce dispositif est une carte à microcircuit de type sans contact, duale ou à contact.

Selon une deuxième variante de réalisation, le module selon l'invention est destiné à être monté sur une carte à microcircuit pour éclairer au moins partiellement une tranche de cette carte.

Cette variante de l'invention met à profit le fait que la majorité des lecteurs de carte à contact laissent apparente la tranche de la carte. L'éclairage de la tranche est en outre particulièrement esthétique et apparent. En effet, lorsque la tranche de la carte est éclairée, l'utilisateur a l'impression globale d'un changement de couleur de la carte qui est particulièrement remarquable.

De préférence, la carte peut comporter deux sources lumineuses ayant deux couleurs distinctes indiquant deux états de communication distincts.

L'invention vise aussi une carte incorporant un module selon cette deuxième variante de réalisation.

Une telle carte peut en outre comporter l'une ou plusieurs des caractéristiques suivantes :
- le corps comprend une région apte à transmettre la lumière émise par le moyen lumineux s'étendant au moins partiellement le long de la tranche, le moyen lumineux étant agencé dans le corps pour éclairer la tranche de la carte au travers de cette région ;
- la région de transmission est réalisée dans un premier matériau et est entourée au moins partiellement par un deuxième matériau, les matériaux étant choisis de manière à former un guide d'onde optique au moins selon une direction ;
- le corps étant formé par une pile de couches s'étendant au travers du corps, la région de transmission forme une des couches de la pile ;
- le moyen lumineux est agencé à l'intérieur de la région de transmission ;
- le moyen lumineux est optiquement dissimulé entre les première et deuxième faces de la carte ;
- la carte comprend un module comprenant le microcircuit et le moyen lumineux, le corps comprenant une cavité de réception du module ;
- la cavité est réalisée au moins partiellement dans l'épaisseur de la région de transmission de manière à ce que le moyen lumineux s'étende au moins partiellement à l'intérieur de la région de transmission ;
- le module comprend un support délimitant une première face destinée à être visible et une deuxième face opposée destinée à être en regard de la cavité, la deuxième face portant au moins le moyen lumineux ;
- la carte comprend une antenne de communication en champ proche raccordée au microcircuit et au moyen lumineux ;
- la carte comprend des première et deuxième antennes de communication en champ proche raccordées respectivement au microcircuit et au moyen lumineux ;
- la carte comprend un module comprenant le microcircuit et le moyen lumineux, l'antenne ou les antennes étant incorporées dans le module ;
- le moyen lumineux est raccordé électriquement à un contact externe d'alimentation s'étendant sur la carte et apte à venir en contact avec un lecteur de carte externe avec contact ;
- le moyen lumineux est apte à être commandé en fonction d'un état de communication du microcircuit ;
- la carte comprend des premier et deuxième moyens lumineux aptes à être commandés en fonction de premier et deuxième états de communication du microcircuit ;
- la carte est une carte à microcircuit de type sans contact, duale ou à contact.

Le dispositif incorporant le module selon l'invention peut avoir une épaisseur égale à 0.76 mm, correspondant au format ISO 7816 +/- 10%.

D'autres caractéristiques et avantages de l'invention apparaîtront à la lumière de la description qui suit, faite en référence aux dessins annexés dans lesquels :
- la figure 1 représente un dispositif électronique comprenant une source lumineuse selon un premier mode de réalisation de l'invention ;
- la figure 2 représente une vue de dessus à échelle agrandie d'un module électronique du dispositif de la figure 1 ;
- la figure 3 représente la vue en coupe selon la ligne III-III de la figure 1 ;
- la figure 4 est une vue en perspective et en détail de la source lumineuse représentée en coupe sur la figure 3 ;
- la figure 5 représente la vue de dessus de la figure 2 avec des éléments représentés en transparence ;
- la figure 6 est une vue de dessus d'une autre carte à microcircuit selon l'invention ;
- la figure 7 représente une vue en coupe de la carte de la figure 1 selon la ligne 7-7 de la figure 6.

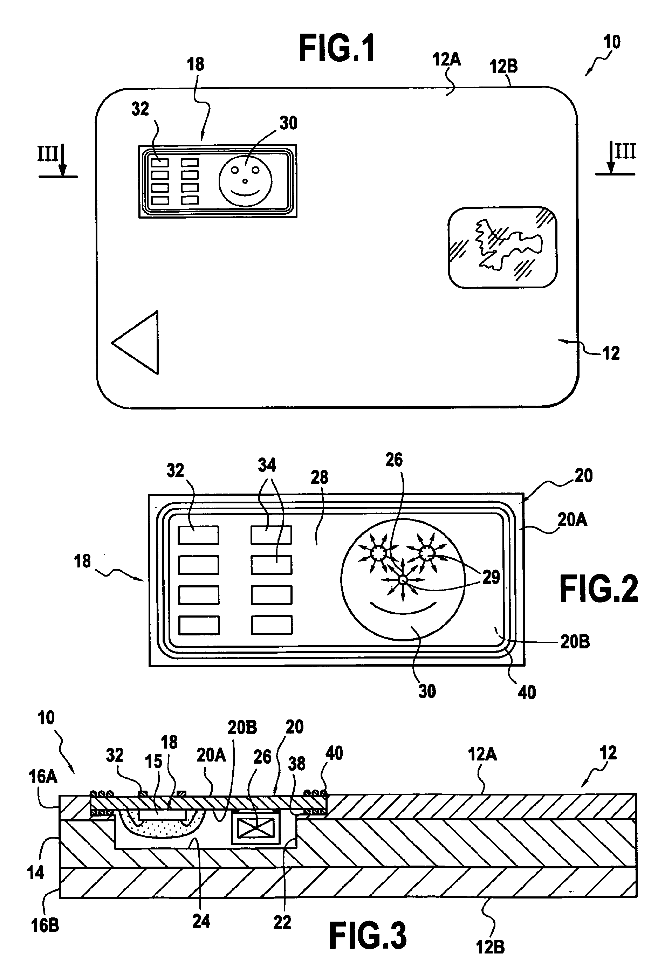

On a représenté sur les figures 1 à 3 un dispositif électronique selon un premier mode de réalisation de l'invention.

Ce dispositif électronique est désigné par la référence générale 10. Le dispositif électronique 10 est, dans le mode de réalisation décrit une carte à microcircuit. En variante, le dispositif 10 peut être une page d'un passeport tel que la couverture du passeport ou encore une étiquette autocollante telle qu'un sticker, etc.

Comme cela est illustré sur la figure 1, le dispositif 10 comprend un corps 12 en forme générale de carte délimitant des première 12A et deuxième 12B faces opposées.

Dans ce mode de réalisation, le corps 12 délimite les dimensions extérieures de la carte 10. Dans cet exemple et de préférence, les dimensions de la carte 10 sont définies par le format ID-1 de la norme ISO 7816 qui est le format classiquement utilisé pour les cartes bancaires de dimensions 86 millimètres par 54 millimètres.

Bien entendu, d'autres formats de cartes peuvent également être utilisés tels que par exemple le format ID-000 de cette même norme.

De préférence, le corps de carte 12 est mis en forme par lamination, c'est-à-dire par la formation, par exemple au moyen d'une presse et dans une opération de lamination à chaud d'une pile de couches ou feuilles laminées réalisées par exemple en matériau thermoplastique.

Par exemple, dans ce mode de réalisation, le corps 12 comprend une pile d'au moins trois couches : une couche centrale 14 formant une couche d'impression de données intercalées entre deux couches externes 16A, 16B de préférence transparentes. Bien entendu, le corps 12 peut être formé d'une seule couche ou de plus de trois couches.

En variante, le corps 12 peut être mis en forme par moulage, par exemple de matière plastique. De façon classique le dispositif 10 comprend un microcircuit 15 apte à échanger, à traiter et/ou à mémoriser des données.

Plus particulièrement, le corps 12 comprend un module électronique 18 selon l'invention. Le module à microcircuit 18 est illustré en détail sur la figure 2. Conformément à l'invention, le module 18 comprend un support 20 délimitant des première 20A et deuxième 20B faces opposées, la première face 20A étant destinée à être visible de l'extérieur alors que la deuxième face 20B, opposée à la première face 20A, est destinée à être masquée lorsque le module 18 est monté dans le dispositif 10.

Comme cela est illustré sur la figure 3, le corps 12 comprend une cavité 22 de réception de ce module 18. Ainsi, le module 18, une fois monté dans le dispositif 10, c'est-à-dire, une fois logé dans la cavité 22, présente une première face externe 20A du support 20 visible de l'extérieur et une deuxième face interne 20B, opposée à la première face 20A, qui est tournée en regard d'un fond 24 de la cavité 22.

Dans une variante non illustrée sur les figures, le module 18 est entièrement incorporé dans le corps, par exemple dans ce cas, le module est visible par transparence d'une partie au moins du corps. Par exemple, cette variante est très bien adaptée au cas où le dispositif est un passeport ou encore un sticker.

Dans le mode de réalisation décrit ici, le module 18 comprend encore une source lumineuse 26 portée par la deuxième face 20B du support 20 et apte à éclairer une partie visible du dispositif, visible de l'extérieur du dispositif, à savoir la première face 20A ou une partie de celle-ci, à travers le support 20. L'agencement de cette source lumineuse 26 permet d'effectuer un rétro-éclairage du support 20.

Par exemple, le support 20 du module 18 comporte au moins une région 28 de transmission de lumière 26 traversant le support 20. La région de transmission 28 peut être formée par l'ensemble du support 20. La région 28 est par exemple translucide voire transparente à la lumière émise par la source 26. La source 26 a un spectre d'émission compris de préférence dans la lumière visible.

De préférence, le support 20 est réalisé dans un matériau apte à transmettre la lumière.

Par exemple, le support 20 est réalisé par exemple dans un matériau comprenant essentiellement du verre époxy qui est un matériau translucide à la lumière visible. En variante, le support 20 peut être réalisé dans un matériau comprenant essentiellement du PET, du téflon, du polyimide, du polyester ou un mélange de ces composés.

De préférence, la source lumineuse 26 est une diode électroluminescente. De façon connue en soi, une diode 26 est un composant électronique capable d'émettre de la lumière lorsqu'elle est parcourue par un courant électrique.

De préférence, la diode 26 est de type CMS (composant monté en surface). Ainsi, de façon classique, un composant monté en surface peut être rapporté sur un substrat d'un circuit imprimé par collage, brasage ou soudage à la différence d'un composant muni de broches traversantes dont l'assemblage au substrat nécessite la formation de trous dans le substrat pour laisser passer les broches.

De préférence, la source lumineuse 26 est agencée pour éclairer le support 20 essentiellement en lumière directe.

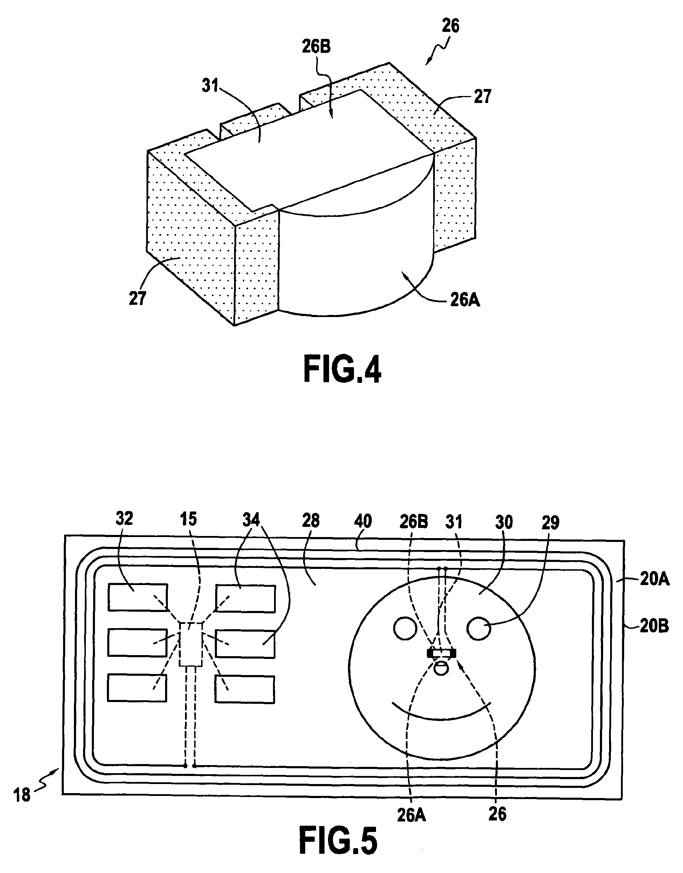

On a représenté sur la figure 4 une vue en détail de la source lumineuse 26. Dans l'exemple décrit, la source lumineuse 26 est formée par un organe comprenant une première partie émettrice de lumière 26A et une deuxième partie 26B formant connecteur électrique de l'organe 26 avec un circuit électronique externe, tel que par exemple une antenne de communication en champ proche.

De préférence, la partie émettrice 26A est agencée au moins partiellement en regard du support 20 de manière à ce qu'elle éclaire ce dernier principalement en lumière directe (par opposition à lumière réfléchie).

La partie émettrice 26A a par exemple la forme d'un demi-disque ou d'une calotte sphérique ou toute autre forme convenable. La partie connecteur 26B forme un plot de connexion muni de deux bornes de connexion latérales 27 et d'une base 31 apte à être fixée sur le support 20.

Dans l'exemple illustré, la diode 26 est assemblée au support 20 du module 18 par soudage ou brasage.

De préférence, dans le mode de réalisation préféré de l'invention illustré sur les figures, le module électronique 18 incorpore le microcircuit 15 de la carte 10.

Dans ce mode de réalisation, le support 20 de la carte 10 comprend en outre une interface externe 32 de plages 34 de contact raccordée électriquement au microcircuit 15. Cette interface 32 permet l'établissement d'une communication avec contact, par exemple lorsque la carte 10 est insérée dans un lecteur de carte adapté.

Cette interface 32 comprend par exemple une série de plages métalliques 34 de contacts électriques conformes à une norme prédéfinie de carte à microcircuit. Par exemple, les plages 34 sont conformes à la norme ISO 7816. Dans ce mode de réalisation, les plages 34 de l'interface 32 correspondent aux contacts C1 à C8 de la norme ISO 7816.

L'interface 32 de la carte 10 est de préférence réalisée dans une couche de matériau métallique telle que du cuivre mais peut également être réalisée, en variante, par sérigraphie d'encre conductrice de type encre époxy chargée de particules d'argent ou d'or ou par sérigraphie d'un polymère électriquement conducteur.

De façon préférentielle, les plages 34 sont raccordées électriquement au microcircuit 15 par des fils électriquement conducteurs (non représentés) tels que par exemple des fils d'or traversant des via ménagés dans le support 20 du module 18, eux-mêmes raccordés à des pistes électriquement conductrices de liaison s'étendant sur la face interne 20B du support 20. Ces pistes n'ont pas été représentées sur la figure 3.

Dans l'exemple décrit, le support 20 porte en outre sur la face visible 20A un motif 30 et la source lumineuse 26 est de préférence dans ce cas agencée pour rétro-éclairer le motif 30.

De préférence, le motif 30 recouvre au moins partiellement la région translucide 28 du support 20. Dans ce cas, la source lumineuse 26 s'étend de préférence sensiblement au droit du motif 30, ce qui permet de rétro-éclairer le motif 30 lorsque la source lumineuse 26 est alimentée.

Le motif 30 représente dans cet exemple un visage, de préférence réalisé dans un matériau non conducteur électriquement. Ainsi, le motif 30 est réalisé par exemple par sérigraphie d'une encre non électriquement conductrice. Le motif 30 présente dans cet exemple illustré des orifices 29 à travers lesquels la lumière est transmise.

En outre, comme cela est illustré sur la figure 3 et de préférence, la cavité 22 comprend par exemple une zone centrale profonde munie d'un fond 24 pour le logement du microcircuit 15 et une zone périphérique surélevée par rapport à la zone centrale délimitant un gradin 38 avec le fond 24. La zone périphérique comprend une surface d'appui surélevée par rapport au fond 24 de la cavité 22 sur laquelle repose les bords du support 20 du module 18.

Une telle cavité 22 est généralement obtenue par usinage, typiquement par fraisage ou lamage en deux opérations :
- un grand lamage pour former la zone périphérique correspondant à la profondeur du gradin 38,
- un petit lamage pour former la zone centrale plus profonde.

Dans le mode de réalisation illustré par les figures 1 à 3, la carte 10 est de type duale, c'est-à-dire qu'elle comprend à la fois une interface sans contact apte à établir une communication en champ proche avec un terminal externe et une interface avec contact 32 apte à établir une communication avec un autre terminal externe par contact. Toutefois, en variante, la carte 10 peut être uniquement de type sans contact. Dans ce cas, la carte 10 est de préférence dépourvue de l'interface 32 de contacts externes.

Pour l'établissement d'une communication sans contact avec un terminal externe, tel qu'un lecteur externe, le dispositif 10 comprend encore une antenne 40 de communication à champ proche. Cette antenne 40 comprend par exemple un enroulement de spires électriquement conductrices comprenant au moins une spire.

Dans le mode de réalisation préféré de l'invention, cette antenne 40 est raccordée au microcircuit 15 pour son alimentation. Par exemple, l'antenne 40 est raccordée au microcircuit 15 au moyen de pistes électriquement conductrices, de vias métallisés, de fils électriquement conducteur, etc (voir figure 5).

L'antenne 40 est de préférence portée également par le module 18. Ainsi, de préférence, l'antenne 40 est portée au moins partiellement par l'une des faces du support 20 du module 18 et de préférence par les deux faces du support 20 du module 18.

Comme cela est illustré sur la figure 2, on voit que le module a un support de forme générale oblongue de manière à ce que l'antenne 40 ait une surface utile correspondant sensiblement aux dimensions du support. Par exemple, le support a pour dimensions 17.8 par 27.2 millimètre et une épaisseur comprise entre 100 et 200 micromètres.

En outre, l'antenne 40 est formée par un enroulement de spires entourant le microcircuit et longeant la périphérie du support 20. Par exemple, l'antenne 40 s'étend sur les deux faces 20A, 20B du support 20 (figure 2).

De préférence, l'antenne 40 est raccordée également à la source lumineuse 26 pour l'alimentation de cette dernière (par exemple par des moyens identiques à ceux utilisés pour le raccordement électrique du microcircuit 15, voir figure 5 également). De façon plus précise, l'antenne 40 et la diode 26 sont configurées pour que la diode 26 émette de la lumière lorsqu'un courant d'intensité prédéfinie circule dans l'antenne 40, c'est-à-dire lorsque la communication en champ proche est établie avec un lecteur de carte externe sans contact.

La configuration du circuit d'antenne formé par l'ensemble du microcircuit 15, de l'antenne 40 et de la diode 26 est définie par des paramètres de configuration choisis parmi une longueur du fil de l'antenne 40, un écart entre deux spires de l'antenne 40, une largeur du fil de l'antenne 40, un nombre de tours de l'antenne 40, ainsi que la capacité de la jonction semi conductrice de la diode 26.

Les paramètres de configuration sont ainsi ajustés de manière à ce que la fréquence de fonctionnement du circuit d'antenne permette la communication en champ proche avec un lecteur de carte externe. Par exemple, la fréquence de fonctionnement est réglée à 13,56 MHz telle que définie par la norme ISO 14443.

Dans un deuxième mode de réalisation de l'invention non illustré sur les figures, le dispositif 10 comprend des première et deuxième antennes de communication en champ proche indépendantes destinées respectivement à alimenter le microcircuit 15 et la source lumineuse 26. Par exemple, dans ce cas, chacune des antennes est portée par une des faces du support du module.

On va maintenant décrire les principaux aspects du fonctionnement de la carte 10 des figures 1 à 3.

Dans un premier temps, l'utilisateur de la carte 10 est à distance d'un terminal externe de lecture sans contact. Lorsqu'il passe à proximité du terminal externe, un couplage électromagnétique entre une antenne du terminal et l'antenne 40 de la carte 10 se produit.

Un courant d'intensité non nulle circule alors dans le circuit d'antenne. Le microcircuit est alimenté permettant l'établissement d'une communication et la diode 26, également parcourue par le courant, s'allume.

Le motif 30 est alors rétro-éclairé ce qui permet d'indiquer à l'utilisateur que l'établissement de la communication sans contact s'est déroulé avec succès.

Le rétro-éclairage du module produit un effet esthétique et de haute technicité tout en étant particulièrement simple à mettre en oeuvre.

Ainsi, un tel module rétro-éclairé présente un grand intérêt pour les cartes duales mais peut trouver également des applications diverses avec d'autres cartes à contact ou sans contact ou d'autres dispositifs électroniques de poche ou portables.

En outre, la source lumineuse utilisée peut être de tout type, par exemple une diode. Le spectre d'émission de la source lumineuse peut être choisi selon le besoin, sans limitation au spectre visible.

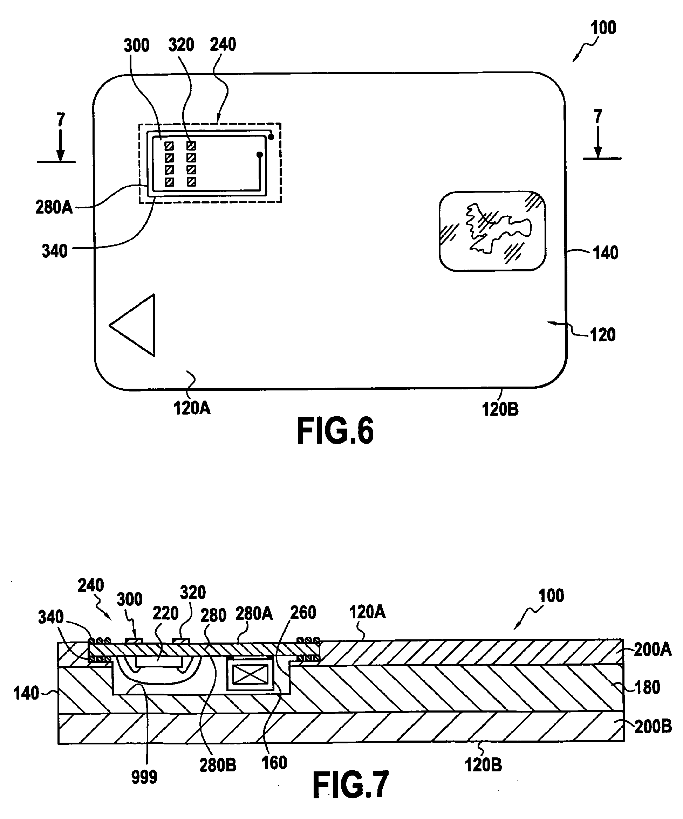

On a représenté sur la figure 6 une carte à microcircuit selon un autre mode de réalisation de l'invention. Cette carte est désignée par la référence générale100.

Comme cela est illustré sur la figure 6, la carte 100 comprend un corps 120 en forme générale de carte délimitant des première 120A et deuxième 120B faces opposées. En outre, le corps 120 délimite sur sa périphérie une tranche 140 de la carte 100. Cette tranche 140 est définie comme étant le bord externe périphérique entourant la carte 100.

Dans ce mode de réalisation, le corps 120 délimite les dimensions extérieures de la carte 100. Dans cet exemple et de préférence, les dimensions de la carte 100 sont définies par le format ID-1 de la norme ISO 7816 qui est le format classiquement utilisé pour les cartes bancaires de dimensions 86 millimètres par 54 millimètres. Bien entendu, d'autres formats de carte peuvent être utilisés dans le cadre de l'invention, tel que par exemple le format ID-000 de cette même norme.

Dans ce mode de réalisation, le corps 120 incorpore un moyen lumineux 160 (ou source lumineuse 160) apte à éclairer de l'intérieur au moins partiellement la tranche 140 de la carte 100, cette partie éclairée de la carte étant visible de l'extérieur de la carte.

A cet effet, de préférence, le corps 120 comprend au moins une région 180 apte à transmettre, dans l'épaisseur de la carte, la lumière émise par le moyen lumineux 160 jusqu'à la tranche 140. Autrement dit, le moyen lumineux 160 est agencé dans le corps 120 pour éclairer la tranche 140 de la carte 100 au travers de cette région de transmission 180.

De préférence, la région de transmission 180 est réalisée dans un premier matériau et est entourée au moins partiellement un deuxième matériau différent du premier matériau.

Dans cet exemple, le corps 120 est formé par une pile de couches s'étendant au travers du corps 12 et la région de transmission 180 forme une des couches de la pile.

Comme cela est illustré sur la figure 7, le corps 120 comprend une pile d'au moins trois couches : une couche centrale 180 formant la région de transmission intercalée entre au moins deux couches externes 200A, 200B dans le deuxième matériau, ces deux couches formant une région dite périphérique.

Ainsi, de préférence, le corps 120 est mis en forme par lamination, c'est-à-dire par formation par exemple au moyen d'une presse et dans une opération de lamination à chaud, de la pile de couches ou feuilles laminées réalisées par exemple en matériau thermoplastique.

Bien entendu, dans une variante non illustrée, le corps 120 peut être mis en forme par moulage, par exemple de matière plastique.

Les matériaux sont choisis de manière à ce que les régions 180, 200A, 200B de transmission et périphériques forment un guide d'onde optique selon au moins une direction.

La couche de transmission 180 est par exemple réalisée en polycarbonate. Eventuellement, la couche peut être réalisée également dans un matériau se présentant sous la forme d'un film de fibres de verre tel que des composés de type LGF (acronyme anglais pour « Light Guide Film ») réalisé par exemple à base de polyuréthane ou d'acrylique.

Par exemple, les couches périphériques 200A, 200B entourant la couche de polycarbonate sont réalisées en PVC (acronyme pour polychlorure de vinyle).

De préférence, afin d'optimiser le guidage optique des ondes, le matériau de la couche de transmission 180 a un indice de réfraction supérieur à l'indice de réfraction des matériaux constituant les deux couches externes 200A, 200B entourant la couche de transmission 18.

De préférence, le moyen 160 émet dans le spectre visible.

De préférence, ces deux couches externes 200A, 200B sont opaques. Ceci permet notamment de mettre en valeur l'éclairage de la tranche de la carte 100.

Dans un mode de réalisation préféré, le moyen lumineux 16 est optiquement dissimulé entre les deux faces 120A, 120B de la carte 100.

Comme cela est illustré sur la figure 7 on voit que le moyen lumineux 160 est de préférence agencé à l'intérieur de la région de transmission 180.

Ainsi, dans le mode de réalisation préféré de l'invention, la carte 100 comprend un microcircuit 220 apte à échanger, à traiter et/ou à mémoriser des données. Dans un mode de réalisation préféré, le corps 120 comprend un module à microcircuit 240 incorporant le microcircuit 220.

Le corps 120 comprend une cavité 260 de réception du module 240, cette cavité 260 étant réalisée au moins partiellement dans l'épaisseur de la région de transmission 180, de manière à ce que le moyen lumineux 160 s'étende au moins partiellement dans la région de transmission 180 lorsque le module 240 est logé dans la cavité 260.

Le module 240 comprend un support 280 délimitant une face externe 280A destinée à être visible et une face interne 280B masquée destinée à être tournée vers la cavité 260 et portant le microcircuit 220 ainsi que le moyen lumineux 160.

Ainsi, de préférence, le moyen lumineux 160 est optiquement dissimulé à l'intérieur de la carte 100 entre les deux faces 120A, 120B de la carte 100. En revanche, le moyen lumineux 160 peut être observé par exemple depuis la tranche 140 de la carte 100.

Dans le cas où le support 280 est translucide et laisse passer la lumière du moyen 160, un cache opaque peut être agencé sur le support 280 sensiblement au droit du moyen lumineux 160. Un motif peut par exemple être imprimé sur la face visible 280A du support 280 pour masquer la lumière émise par la source 160. En variante, le support 280 peut également être choisi opaque.

Toutefois, l'éclairage du module 240 par la source 160 peut également être mis à profit pour apporter un effet esthétique ou technique supplémentaire.

Dans le mode de réalisation préféré de l'invention, la carte 100 est de type duale, c'est-à-dire qu'elle permet à la fois une communication à contact et une communication sans contact.

A cet effet, le module à microcircuit 240 comprend également une interface 300 de contact reliée électriquement au microcircuit 220. Cette interface 300 permet l'établissement d'une communication à contact de la carte 100, lorsque cette dernière est insérée dans un lecteur de carte adapté. L'interface 300 est par exemple portée par la face externe 280A du support 280 du module 240.

Cette interface 300 comprend par exemple une série de plages 320 métalliques de contacts électriques, conformes à une norme prédéfinie de carte à microcircuit. Par exemple, les plages de contacts sont conformes à la norme ISO 7816. Dans ce mode de réalisation, les plages 320 de contact d'interface 300 correspondent aux contacts C1 à C8 de la norme ISO 7816.

L'interface 300 de la carte 10 est de préférence réalisée dans une couche de matériau métallique telle que du cuivre mais peut également être réalisée en variante, par sérigraphie d'encre conductrice de type encre époxy chargée de particules d'argent ou d'or ou par sérigraphie d'un polymère électriquement conducteur.

De façon préférentielle, les plages sont raccordées électriquement au microcircuit par des fils électriquement conducteurs tels que par exemple des fils d'or traversant des vias ménagés dans le support du module, eux-mêmes raccordés à des pistes électriquement conductrices de liaison s'étendant sur la face interne du support. Ces pistes n'ont pas été représentées sur la figure 7

Pour l'établissement d'une communication sans contact avec un terminal externe, tel qu'un lecteur externe, la carte 100 comprend également au moins une antenne de communication en champ proche 340.

L'antenne 340 est raccordée, conformément à l'invention, de préférence au microcircuit 220 et est apte à alimenter le microcircuit 220 par couplage électromagnétique avec un terminal externe (non représenté).

La fréquence de communication du microcircuit avec le terminal externe est de préférence la fréquence de communication de 13,56 MHz définie par la norme ISO 14 443.

De préférence, l'antenne 340 est également raccordée au moyen lumineux 160 pour son alimentation.

Dans une variante de l'invention, la carte 100 comprend des première et deuxième antennes raccordées respectivement au microcircuit 220 et au moyen lumineux 160. Par exemple, l'antenne 340 s'étend à l'intérieur du module 240. De préférence, l'antenne 340 s'étend sur le support 280, par exemple sur les deux faces opposées du support de sorte que l'antenne 340 est visible partiellement depuis l'extérieur.

De préférence, la source lumineuse 160 est une diode électroluminescente. De façon connue en soi, une diode est un composant électronique capable d'émettre de la lumière lorsqu'elle est parcourue par un courant électrique. De préférence, la diode est de type CMS c'est-à-dire composant monté en surface.

Ainsi, de façon classique, un composant monté en surface peut être rapporté sur un substrat d'un circuit imprimé par collage, par brasage ou soudage, à la différence d'un composant muni de broches traversantes dont l'assemblage au substrat nécessite la formation de trous dans le substrat pour laisser passer les broches.

Dans l'exemple illustré sur la figure 7, la diode 160 est assemblée au support 280 du module 240 par soudage ou brasage. Par exemple, l'antenne 340 est raccordée au moyen lumineux 160 et dans ce cas le moyen lumineux 160 est alimenté par l'antenne 340.

Dans une variante, le moyen lumineux 160 est raccordé électriquement à un contact externe d'alimentation s'étendant sur la carte 100, par exemple un des contacts d'alimentation de l'interface 300 de contacts 320.

De préférence, le moyen lumineux 160 est apte à être commandé en fonction d'un état de communication du microcircuit 220, par exemple en fonction de l'état d'une transaction.

En variante, la carte 100 peut être uniquement de type sans contact, dans ce cas, la carte 100 est de préférence dépourvue de l'interface de contact externe. Dans une autre variante, la carte 100 peut être uniquement de type à contact et dans ce cas, la carte 100 est dépourvue de l'antenne de communication à champ proche.

Dans un autre mode de réalisation de l'invention non illustré sur les figures, la carte 100 peut comprendre au moins deux moyens lumineux. Par exemple, les deux moyens lumineux sont aptes à être commandés en fonction de premier et deuxième états de communication du microcircuit.

Ceci permet à l'utilisateur de détecter de façon remarquable deux états de communication distincts du microcircuit ce qui, dans certaines applications, peut permettre de réduire les erreurs de sélection d'applications par l'utilisateur, notamment lorsque la carte fonctionne en mode à contact et est insérée dans un lecteur de carte.

En effet, dans ce cas, l'utilisateur perçoit nettement le changement de couleur de la carte puisque cette dernière est éclairée le long de la tranche.

On va maintenant décrire les principaux aspects de fonctionnement de la carte illustrée par les figures 6 et 7.

Initialement, l'utilisateur est hors de portée d'un terminal externe de contact. Lorsqu'il approche la carte du terminal externe, cette dernière s'allume le long de la tranche. Ce changement d'état de la carte est immédiatement perçu par l'utilisateur.

En outre, lorsque l'utilisateur insère la carte dans un lecteur de carte à contact, le voyant lumineux est alimenté via l'interface de contact 300 et la tranche de la partie de la carte qui dépasse hors du lecteur de carte est également éclairée.

En particulier, le moyen lumineux peut être incorporé dans le corps. Par exemple, le moyen lumineux est raccordé à une antenne de communication en champ proche pour son alimentation, l'ensemble étant disposé sur une couche d'une pile de couches laminées entre elles formant le corps de la carte.

## Revendications

1. Module à microcircuit (18) apte à être monté sur une cavité (24) du corps (12) d'un dispositif électronique portable ou de poche (10), tel qu'une carte à microcircuit, ce module (18) comprenant un support (20) délimitant des première (20A) et deuxième (20B) faces externes opposées, la première face externe (20A) étant destinée à être tournée vers l'extérieur du dispositif électronique (10) de sorte à être visible, la deuxième face externe (20B) étant destinée à être agencée en regard d'un fond (24) de la cavité (22), ce module comportant une source lumineuse (26) portée par la deuxième face externe (20B) et de sorte à éclairer la première face externe (20A) du support (20) au travers du support (20).

2. Module (18) selon la revendication 1, dans lequel le support (20) porte sur la première face (20A) un motif (30) et la source lumineuse (26) est agencée pour rétro-éclairer le motif (30).

3. Module (18, 240) selon la revendication 1 ou 2, comprenant un microcircuit (15, 220) porté par la deuxième face (20B, 280B) du support (20, 280).

4. Module (18, 240) selon la revendication 3, comprenant une interface (32, 320) de contacts externes raccordée électriquement au microcircuit (15, 220) et portée par la première face (20A, 280A) du support (20, 280).

5. Module (18, 240) selon la revendication 3 ou 4, comprenant une antenne (40, 340) de communication en champ proche raccordée électriquement au microcircuit (15, 220).

6. Module (18, 240) selon l'une quelconque des revendications 1 à 5, comprenant une antenne (40, 340) de communication en champ proche raccordée électriquement à la source lumineuse (26, 160).

7. Module (18, 240) selon la revendication 3 ou 4, le module (18, 240) comprend des première et deuxième antennes de communication en champ proche aptes à alimenter respectivement le microcircuit (15, 220) et la source lumineuse (26, 160).

8. Module (18, 240) selon la revendication 3 ou 4, comprenant une antenne de communication en champ proche apte à alimenter simultanément le microcircuit (15, 220) et la source lumineuse (26, 160).

9. Module (18) selon l'une quelconque des revendications 1 à 8, dans lequel la source lumineuse (26, 160) comprend une diode électroluminescente.

10. Module (18) selon la revendication 1, dans lequel le support (20) est réalisé dans un matériau comprenant essentiellement du verre-époxy, du polyimide, du teflon, du polyester, ou du PET.

11. Module (18) selon la revendication 1, dans lequel la source lumineuse (26) est agencée pour éclairer le support (20) en lumière directe.

12. Module (18) selon la revendication 11, dans lequel la source lumineuse (26) est formée par un organe comprenant une partie émettrice de lumière agencée au moins partiellement en regard du support (20).

13. Carte à microcircuit (100) comportant un module à microcircuit (240) monté sur une cavité (260) du corps (120) de la carte à microcircuit, ce module (240) comprenant un support (280) délimitant des première (280A) et deuxième (280B) faces externes opposées, la première face externe (280A) étant tournée vers l'extérieur de la carte à microcircuit (100) de sorte à être visible, la deuxième face externe (280B) étant agencée en regard d'un fond (999) de la cavité (260), ce module comportant une source lumineuse (160) portée par la deuxième face externe (220B),
la carte comportant dans son épaisseur une région dite de transmission (180) au travers de laquelle la lumière émise par ladite source (160) peut être transmise, ladite source lumineuse (160) étant agencée sur ladite deuxième face externe (280B) pour éclairer au moins une partie d'une tranche (140) de ladite carte (100) sensiblement perpendiculaire auxdites faces opposées (280A, 280B) lorsque le module est agencé sur ladite cavité (260), ladite région de transmission (180) étant réalisée dans un premier matériau et entourée au moins partiellement par un deuxième matériau différent du premier matériau, les matériaux étant choisis pour former un guide d'onde optique au moins selon une direction.

14. Carte à microcircuit selon la revendication 13, dans laquelle, le corps (120) de la carte (100) étant formé par une pile de couches s'étendant au travers du corps (120), la région de transmission (180) forme une des couches de la pile.

15. Carte (100) selon la revendication 14 ou 15, dans laquelle le moyen lumineux (160) est agencé à l'intérieur de la région de transmission (180).

16. Carte (100) selon la revendication 15, dans laquelle le moyen lumineux (160) est optiquement dissimulé entre les première (120A) et deuxième (120B) faces de la carte (100).

17. Carte (100) selon l'une quelconque des revendications 13 à 16, dans laquelle la cavité (260) est réalisée au moins partiellement dans l'épaisseur de la région de transmission (180) de manière à ce que le moyen lumineux (160) s'étende au moins partiellement à l'intérieur de la région de transmission (180).

18. Carte (100) selon l'une quelconque des revendications 13 à 17, dans laquelle le moyen lumineux (160) est apte à être commandé en fonction d'un état de communication du microcircuit (220).

19. Carte (100) selon la revendication 18, comprenant des premier et deuxième moyens lumineux aptes à être commandés en fonction de premier et deuxième états de communication du microcircuit (220).

20. Carte (10) selon l'une quelconque des revendications 13 à 19, étant une carte à microcircuit de type sans contact, duale ou à contact.

21. Dispositif électronique portable ou de poche (10), tel qu'une carte à microcircuit, comprenant un module à microcircuit (18) selon la revendication 1, et un corps (12) muni d'une cavité (22) de réception du module (18).

22. Dispositif (10) selon la revendication 21, étant une carte à microcircuit (10) de type sans contact, duale ou à contact.

## Patentansprüche

1. Mikroschaltkreismodul (18), das geeignet ist, auf einer Vertiefung (24) des Körpers (12) einer elektronischen Vorrichtung (10), portabel oder für die Tasche, wie einer Mikrochipkarte, angebracht zu werden, wobei dieses Modul (18) einen Träger (20) umfasst, welcher gegenüberliegende erste (20A) und zweite (20B) Außenseiten begrenzt, wobei die erste Außenseite (20A) dazu bestimmt ist, der Außenseite der elektronischen Vorrichtung (10) zugewandt zu werden, so dass sie sichtbar ist, wobei die zweite Außenseite (20B) dazu bestimmt ist, gegenüber einem Grund (24) der Vertiefung (22) angeordnet zu werden, wobei dieses Modul eine Lichtquelle (26) umfasst, die durch die zweite Außenseite (20B) getragen ist, derart, dass sie die erste Außenseite (20A) des Trägers (20) durch den Träger (20) hindurch beleuchtet.

2. Modul (18) nach Anspruch 1, bei dem der Träger (20) auf der ersten Seite (20A) ein Muster (30) trägt und die Lichtquelle (26) dazu eingerichtet ist, das Muster (30) von hinten zu beleuchten.

3. Modul (18, 240) nach Anspruch 1 oder 2, umfassend einen Mikroschaltkreis (15, 220), der durch die zweite Seite (20B, 280B) des Trägers (20, 280) getragen ist.

4. Modul (18, 240) nach Anspruch 3, umfassend eine Schnittstelle (32, 320) für Außenkontakte, die mit dem Mikroschaltkreis (15, 220) elektrisch verbunden und durch die erste Seite (20A, 280A) des Trägers (20, 280) getragen ist.

5. Modul (18, 240) nach Anspruch 3 oder 4, umfassend eine Antenne (40, 340) zur Nahfeldkommunikation, die mit dem Mikroschaltkreis (15, 220) elektrisch verbunden ist.

6. Modul (18, 240) nach einem der Ansprüche 1 bis 5, umfassend eine Antenne (40, 340) zur Nahfeldkommunikation, die mit der Lichtquelle (26, 160) elektrisch verbunden ist.

7. Modul (18, 240) nach Anspruch 3 oder 4, wobei das Modul (18, 240) eine erste und eine zweite Antenne zur Nahfeldkommunikation umfasst, die geeignet sind, den Mikroschaltkreis (15, 220) bzw. die Lichtquelle (26, 160) zu versorgen.

8. Modul (18, 240) nach Anspruch 3 oder 4, umfassend eine Antenne zur Nahfeldkommunikation, die geeignet ist, gleichzeitig den Mikroschaltkreis (15, 220) und die Lichtquelle (26, 160) zu versorgen.

9. Modul (18) nach einem der Ansprüche 1 bis 8, bei dem die Lichtquelle (26, 160) ein Leuchtdiode umfasst.

10. Modul (18) nach Anspruch 1, bei dem der Träger (20) aus einem Material gefertigt ist, das im Wesentlichen glasfaserverstärktes Epoxidharz, Polyimid, Teflon, Polyester oder PET umfasst.

11. Modul (18) nach Anspruch 1, bei dem die Lichtquelle (26) dazu eingerichtet ist, den Träger (20) mit direktem Licht zu beleuchten.

12. Modul (18) nach Anspruch 11, bei dem die Lichtquelle (26) durch ein Organ gebildet ist, das einen lichtemittierenden Teil, welcher wenigstens teilweise gegenüber dem Träger (20) angeordnet ist, umfasst.

13. Mikrochipkarte (100), umfassend ein Mikroschaltkreismodul (240), das auf einer Vertiefung (260) des Körpers (120) der Mikrochipkarte angebracht ist, wobei dieses Modul (240) einen Träger (280) umfasst, welcher gegenüberliegende erste (280A) und zweite (280B) Außenseiten begrenzt, wobei die erste Außenseite (280A) der Außenseite der Mikrochipkarte (100) zugewandt ist, so dass sie sichtbar ist, wobei die zweite Außenseite (280B) gegenüber einem Grund (999) der Vertiefung (260) angeordnet ist, wobei dieses Modul eine Lichtquelle (160), die durch die zweite Außenseite (220B) getragen ist, umfasst,
wobei die Karte in ihrer Dicke einen sogenannten Transmissionsbereich (180) umfasst, durch den hindurch das durch die Quelle (160) emittierte Licht transmittiert werden kann, wobei die Lichtquelle (160) auf der zweiten Außenseite (280B) angeordnet ist, um wenigstens einen Teil einer Kante (140) der Karte (100), die zu den gegenüberliegenden Seiten (280A, 280B) im Wesentlichen senkrecht verläuft, zu beleuchten, wenn das Modul auf der Vertiefung (260) angeordnet ist, wobei der Transmissionsbereich (180) aus einem ersten Material ausgebildet ist und wenigstens teilweise von einem von dem ersten Material verschiedenen zweiten Material umgeben ist, wobei die Materialien dazu ausgewählt sind, einen Lichtwellenleiter wenigstens entlang einer Richtung zu bilden.

14. Mikrochipkarte nach Anspruch 13, bei der, wenn der Körper (120) der Karte (100) durch einen Stapel von Schichten gebildet ist, die sich durch den Körper (120) erstrecken, der Transmissionsbereich (180) eine der Schichten des Stapels bildet.

15. Karte (100) nach Anspruch 14 oder 15, bei der das Leuchtmittel (160) innerhalb des Transmissionsbereichs (180) angeordnet ist.

16. Karte (100) nach Anspruch 15, bei der das Leuchtmittel (160) zwischen der ersten (120A) und der zweiten (120B) Seite der Karte (100) optisch kaschiert ist.

17. Karte (100) nach einem der Ansprüche 13 bis 16, bei der die Vertiefung (260) wenigstens teilweise in der Dicke des Transmissionsbereichs (180) ausgebildet ist, so dass das Leuchtmittel (160) sich wenigstens teilweise innerhalb des Transmissionsbereichs (180) erstreckt.

18. Karte (100) nach einem der Ansprüche 13 bis 17, bei der das Leuchtmittel (160) geeignet ist, in Abhängigkeit von einem Kommunikationszustand des Mikroschaltkreises (220) betätigt zu werden.

19. Karte (100) nach Anspruch 18, umfassend ein erstes und ein zweites Leuchtmittel, die geeignet sind, in Abhängigkeit von einem ersten und einem zweiten Kommunikationszustand des Mikroschaltkreises (220) betätigt zu werden.

20. Karte (10) nach einem der Ansprüche 13 bis 19, wobei sie eine Mikrochipkarte vom kontaktlosen, dualen Typ oder vom Typ mit Kontakt ist.

21. Elektronische Vorrichtung (10), portabel oder für die Tasche, wie eine Mikrochipkarte, umfassend ein Mikroschaltkreismodul (18) nach Anspruch 1 und einen Körper (12), der mit einer Vertiefung (22) zur Aufnahme des Moduls (18) ausgestattet ist.

22. Vorrichtung (10) nach Anspruch 21, wobei sie eine Mikrochipkarte (10) vom kontaktlosen, dualen Typ oder vom Typ mit Kontakt ist.

## Claims

1. Microcircuit module (18) which is to be mounted on a cavity (24) of the body (12) of a portable or pocket electronic device (10), such as a microcircuit card, this module (18) comprising a substrate (20) delimiting first (20A) and second (20B) opposite external faces, the first external face (20A) being designed to be oriented towards the outside of the electronic device (10) so that it is visible, the second external face (20B) being designed to be oriented towards the bottom (24) of the cavity (22), this module including a light source (26) borne by the second external face (20B) and so that it lights the first external face (20A) of the substrate (20) through the substrate (20).

2. Module (18) according to claim 1, wherein the substrate (20) bears on the first face (20A) a design (30) and the light source (26) is arranged so as to backlight the design (30).

3. Module (18, 240) according to claim 1 or 2, including a microcircuit (15, 220) borne by the second face (20B, 280B) of the substrate (20, 280).

4. Module (18, 240) according to claim 3, comprising an interface (32, 320) of external contacts electrically connected to the microcircuit (15, 220) and borne by the first face (20A, 280A) of the substrate (20, 280).

5. Module (18, 240) according to claim 3 or 4, including a near-field communication antenna (40, 340) electrically connected to the microcircuit (15, 220).

6. Module (18, 240) according to any one of claims 1 to 5, including a near-field communication antenna (40, 340) electrically connected to the light source (26, 160).

7. Module (18, 240) according to claim 3 or 4, the module (18, 240) including first and second near-field communication antennas capable of supplying power to the microcircuit (15, 220) and the light source (26, 160) respectively.

8. Module (18, 240) according to claim 3 or 4, including a near-field communication antenna capable of simultaneously supplying power to the microcircuit (15, 220) and the light source (26, 160).

9. Module (18) according to any one of claims 1 to 8, wherein the light source (26, 160) comprises a light-emitting diode.

10. Module (18) according to claim 1, wherein the substrate (20) is made of a material comprised essentially of glass-epoxy, of polyimide, of Teflon, of polyester or of PET.

11. Module (18) according to claim 1, wherein the light source (26) is arranged so as to illuminate the substrate (20) in direct light.

12. Module (18) according to claim 11, wherein the light source (26) consists of a component comprising a light-emitting part arranged at least partially facing the substrate (20).

13. Microcircuit card (100) comprising a microcircuit module (240) mounted on a cavity (260) of the body (120) of the microcircuit card, this module (240) comprising a substrate (280) delimiting first (280A) and second (280B) opposite external faces, the first external face (280A) being oriented toward the outside of the microcircuit card (100) so that it is visible, the second external face (280B) being oriented toward a bottom (999) of the cavity (260), this module comprising a light source (160) borne by the second external face (220B),
the card comprising in its thickness a so-called transmission region (180) through which the light emitted by said source (160) can be transmitted, said light source (160) being borne on said second external face (280B) to illuminate at least a part of an edge (140) of said card (100) substantially perpendicular to said opposite faces (280A, 280B), when the module is disposed on said cavity (260),
said transmission region (180) being made of a first material and surrounded at least partially by a second material different from the first material, the materials being selected to constitute an optical waveguide in at least one direction.

14. Microcircuit card according to claim 13, wherein, the body (120) of the card (100) consisting of a stack of layers extending through the body (120), the transmission region (180) constitutes one of the layers of the stack.

15. Card (100) according to claim 14 or 15, wherein the indicator light (160) is arranged within the transmission region (180).

16. Card (100) according to Claim 15, wherein the luminous means (160) is optically concealed between the first (120A) and second (120B) faces of the card (100).

17. Card (100) according to any one of claims 13 to 16, wherein the cavity (260) is made at least partially within the thickness of the transmission region (180) so that the luminous means (160) extends at least partially into the transmission region (180).

18. Card (100) according to any one of claims 13 to 17, wherein the luminous means (160) is capable of being controlled according to a communication state of the microcircuit (220).

19. Card (100) according to claim 18, including first and second luminous means capable of being controlled according to first and second communication states of the microcircuit (220).

20. Card (100) according to any one of claims 13 to 19, being a microcircuit card of the contactless, dual or contact type.

21. Portable or pocket electronic device (10), such as a microcircuit card, comprising a microcircuit module (18) according to claim 1, and a body (12) provided with a cavity (22) for receiving the module (18).

22. Device (10) according to claim 21, being a microcircuit card (10) of the contactless, dual or contact type.
